# FASCICULE DE BREVET EUROPEEN

(11) **EP 2 980 869 B1**
(45) Date de publication et mention de la délivrance du brevet: **03.07.2019**
(21) Numéro de dépôt: 15179271.0
(22) Date de dépôt: 31.07.2015
(51) Int. Cl.: H01L 33/00, H01L 33/62, H01L 33/54, H01L 33/48

(54) **PROCÉDÉ DE FABRICATION DE CIRCUITS INTÉGRÉS À DIODES ÉLECTRO- LUMINESCENTES ET CIRCUITS INTÉGRÉS OBTENUS PAR CE PROCÉDÉ**
HERSTELLUNGSVERFAHREN VON INTEGRIERTEN SCHALTKREISEN MIT LEUCHTDIODEN, UND DURCH DIESES VERFAHREN ERHALTENE INTEGRIERTE SCHALTKREISE
METHOD FOR MANUFACTURING INTEGRATED CIRCUITS WITH LIGHT-EMITTING DIODES AND INTEGRATED CIRCUITS OBTAINED BY SAID METHOD

(30) Priorité: 02.08.2014 FR 1457551
(43) Date de publication de la demande: 03.02.2016
(73) Titulaire: Linxens Holding, 78280 Guyancourt (FR)
(72) Inventeur: Eymard, Eric, 43000 POLIGNAC (FR)
(74) Mandataire: GIE Innovation Competence Group

(56) Documents cités:
- EP-A2- 2 372 796
- WO-A1-2007/018560
- CN-A- 101 296 540
- JP-A- 2003 345 268
- US-A1- 2009 108 282
- US-A1- 2012 261 689

## Description

L'invention concerne de domaine de la fabrication de dispositifs d'éclairage à diodes-électroluminescentes.

Plus précisément, l'invention porte sur un procédé de fabrication de circuits intégrés (« dice en anglais ») comprenant des diodes électroluminescentes. Pour chaque diode électroluminescente, un circuit intégré comprend une anode et une cathode isolées électriquement l'une de l'autre et intégrées sur ou dans par une structure isolante. La diode électroluminescente est alors électriquement connectée entre l'anode et la cathode, par exemple par des fils conducteurs (technique du « wire bonding » en anglais), par la technologie de puce retournée (« flip chip » en anglais) ou par une combinaison de ces deux techniques.

On connait, par exemple par le document EP2755246A2, un tel circuit intégré dans lequel la structure isolante est surmoulée sur l'anode et la cathode, en laissant une ouverture pour une diode électroluminescente. L'anode et la cathode sont réalisées par la technologie des « grilles de connexion » (« lead frame » en anglais). L'ouverture autour de la diode électroluminescente est ensuite remplie d'une résine protégeant à la fois la diode électroluminescente et ses fils conducteurs de connexion, et diffusant la lumière émise par la diode électroluminescente.

On connait également par les documents WO2014113045A1 et KR1020120063703A le fait de réaliser de tel circuits par des techniques habituellement utilisées dans le domaine de la fabrication de circuits imprimés flexibles. On connait également par le document US2009/108282A1 un procédé de fabrication de circuits intégrés à diodes électroluminescentes dans lequel une diode est connectée à l'aide de fils passant par des trous borgnes réalisés par laser.

Un but de l'invention est de fabriquer des circuits intégrés à diodes électroluminescentes par des procédés différents de ceux mentionnés ci-dessus.

Ce but est au moins en partie atteint avec un procédé de fabrication de circuits intégrés à diode électroluminescente selon la revendication 1.

Grâce à ce procédé, l'anode et la cathode se trouvent sous le circuit intégré, c'est-à-dire sur sa face opposée à la face éclairante et le circuit intégré peut être ainsi directement reporté et connecté sur des dispositifs tels que, par exemple, des rubans d'éclairage ou des modules à intégrer dans des lampes. Par ailleurs, les différentes étapes du procédé sont aisément mises en oeuvre dans un procédé en continu et notamment l'étape de perforation du substrat et du premier feuillet de matériau conducteur qui peut être réalisé de manière simplifiée, par poinçonnage par exemple.

Le procédé selon l'invention comporte éventuellement l'une et/ou l'autre des caractéristiques suivantes, considérées indépendamment les unes des autres ou en combinaison :
- la diode électroluminescente est connectée à l'anode et à la cathode par des fils électriquement conducteurs passant par les puits de connexion ;
- on réalise un puits de connexion électriquement conducteur relié électriquement avec l'anode ou la cathode, on réalise au moins un plot de connexion sur la première face principale du substrat, relié électriquement au puits de connexion et on connecte la diode électroluminescente à ce plot de connexion avec un fil conducteur ;
- une piste de matériau conducteur formant une forme géométrique fermée est réalisée sur la première face du substrat et la résine est dispensée sur la diode électroluminescente à l'intérieur de la forme géométrique fermée.

L'invention concerne également un circuit intégré obtenu par ce procédé, ainsi qu'un ensemble de circuits intégrés réalisés sur un même substrat et électriquement connectés entre par des pistes conductrices se trouvant sur au moins l'une des première et deuxième faces principales du substrat.

L'invention décrit un procédé de fabrication de circuits intégrés, à diode électroluminescente selon la revendication 1. D'autres caractéristiques optionnelles de la presente invention sont mentionnées dans les revendications dépendantes.

D'autres caractéristiques et avantages de l'invention apparaîtront à la lecture de la description détaillée et des dessins annexés sur lesquels :
- les figures 1a à 1g représentent schématiquement en coupe différentes étapes d'un exemple de procédé de réalisation d'un circuit intégré conforme à l'invention ;
- les figures 2a et 2b représentent schématiquement respectivement vu de dessous et vu de dessus un ensemble de circuits intégrés à différentes étapes du procédé illustré par les figures 1a à 1g ;
- la figure 3 représente schématiquement en perspective, un exemple de circuit intégré réalisé conformément au procédé illustré par les figures 1a à 1g, 2a et 2b.

Sur ces figures, les mêmes références sont utilisées pour désigner des éléments identiques ou similaires.

L'invention est illustrée dans la suite à l'aide d'un exemple de mode de réalisation particulier d'un circuit intégré 100.

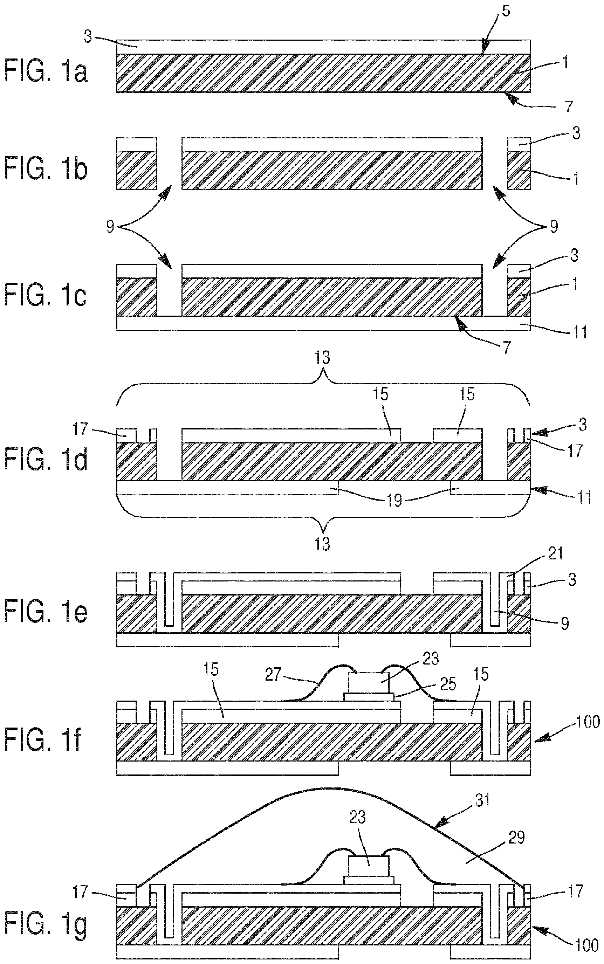

Comme représenté sur la figure 1a, on fournit, dans un procédé en continu, un substrat 1 diélectrique, flexible et colaminé avec un premier feuillet 3 électriquement conducteur. Le substrat 1 est par exemple constitué de verre époxy, ou de PVC ou de polyimide ou tout autre matériau diélectrique flexible approprié. Le substrat diélectrique se présente sous forme d'une bande s'étendant essentiellement dans deux directions et ayant une épaisseur limitée par une première 5 et une deuxième 7 face principales. Le premier feuillet 3 est par exemple constitué d'un alliage de cuivre (dans ce cas l'ensemble du substrat 1 et du premier feuillet 3 constitue un stratifié cuivré - « copper clad » en anglais). Le premier feuillet 3 recouvre essentiellement la première face 5 du substrat 1.

L'ensemble du substrat 1 et du premier feuillet 3 est ensuite perforé de part en part, à travers l'épaisseur de l'ensemble, afin de réaliser des vias ou puits de connexion 9 (voir figure 1b).

Après perforation, un deuxième feuillet 11 électriquement conducteur est déposé, par exemple par collage sur la deuxième face du substrat 7. Ce deuxième feuillet 11 obture donc les puits de connexion 9 pour former des trous borgnes. Il est par exemple constitué également d'un alliage de cuivre (voir Fig. 1c).

Des motifs 13 sont ensuite réalisés sur les premier 3 et deuxième 11 feuillets par des techniques de photolithographie et gravure. À l'issue de ces étapes (voir figure 1d), on obtient un circuit imprimé comportant essentiellement :
- un réseau de plots de connexion 15 gravés dans le premier feuillet 3,
- un réseau de barrières 17 (par exemple chacune circulaire) gravées dans le premier feuillet 3, permettant de contenir une résine comme ce sera expliqué plus loin, et
- un réseau d'anodes et cathodes 19 gravées dans le deuxième feuillet 11.

Les barrières 17 sont donc constituées chacune respectivement d'une piste de matériau conducteur formant une forme géométrique fermée. Cette forme géométrique est par exemple circulaire, mais d'autres formes pourraient être envisagées (par exemple oblongue ou allongée pour couvrir tout une série de diodes électroluminescentes).

Le premier feuillet 3 reçoit ensuite, par exemple par des techniques de photolithographie et électrodéposition, une ou plusieurs couches 21 de matériau conducteur (par exemple 3µm de nickel et 100nm d'argent) afin de métalliser les puits de connexion 9 et de relier ainsi électriquement les premier 3 et deuxième 11 feuillets conducteurs (voir figure 1e). Avantageusement, la dernière couche 21 déposée constitue une surface réfléchissante de couleur appropriée pour réfléchir la lumière (argentée par exemple).

Une ou plusieurs diodes électroluminescentes 23 et Zehner sont collées et connectées aux plots de connexion du premier feuillet 3 (voir figure 1f). La pâte adhésive 25 utilisée pour coller les diodes 23 est avantageusement recuite avant la connexion de celles-ci aux plots de connexion 15. La connexion de chaque diode 23 est par exemple réalisée à l'aide de fils conducteurs 27 (fils d'or de 25 microns de diamètre par exemple). Alternativement cette connexion peut être réalisée par la technique de la « puce retournée ».

Chaque circuit intégré 100 ainsi réalisé reçoit ensuite une résine 29 d'encapsulation (voir figure 1g). Cette résine 29 protège là où les diodes électroluminescentes 23 et leur connexion, et permet également de diffuser la lumière. La résine 29 est déposée sur chaque circuit intégré 100 en quantité adaptée pour constituer une lentille 31 de forme appropriée. La barrière 17 limite la zone sur laquelle la résine 29 peut s'étaler. Ainsi on peut définir la forme de la lentille 31 en ajustant notamment
- le diamètre de la barrière 17,
- la quantité de résine 29 déposée sur chaque circuit intégré 100, et
- la viscosité de la résine 29.

La résine 29 est recuite pour la solidifier.

La couleur de la lumière émise par le circuit intégré 100 peut être ajustée en ajoutant à la résine 29 des additifs tels que du phosphore.

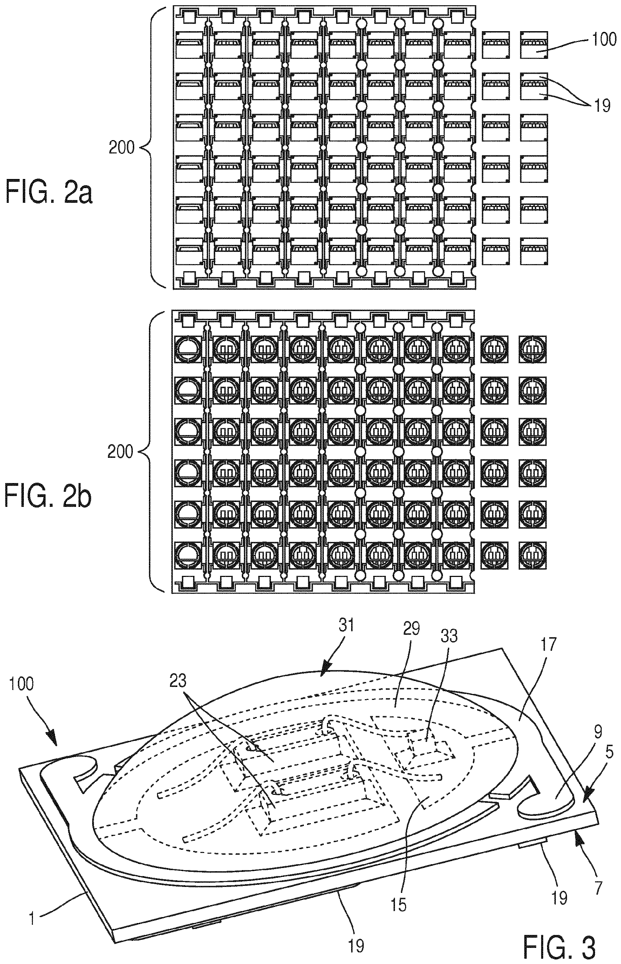

Comme représenté sur les figures 2a et 2b, les circuits intégrés 100 ainsi obtenus en bande 200 par le procédé en continu décrit ci-dessus peuvent être ensuite individualisés avant d'être reportés dans des dispositifs plus complexes.

Alternativement, on peut conserver des circuits intégrés sur une bande 200, électriquement connectés entre eux, pour former des modules plus complexes qui seront intégrés dans des dispositifs tels que des lampes.

Un exemple de circuit intégré obtenu par ce procédé est représenté sur la figure 3. Celui-ci comporte deux diodes électroluminescentes 23 ainsi qu'une diode Zehner 33. Dans ce cas, les puits de connexion 9 entre les plots de connexion 15 d'une part, et l'anode de la cathode 19 d'autre part, sont réalisés à l'extérieur du périmètre défini par la barrière 17 pour la résine 29.

Alternativement, on peut utiliser un substrat 1 avec un feuillet conducteur uniquement sur la deuxième face 7, la connexion des diodes 23, 33, à l'anode et la cathode 19 étant réalisée par des fils de connexion 27 soudés directement au fond des puits de connexion 9, à travers le substrat 1.

Alternativement, les plots de connexion 15, d'une part et/ou l'anode et la cathode 19 d'autre part, peuvent être obtenus sous forme de grille de connexion (« lead frame ») avant d'être reportés sur l'une des première 5 et deuxième 7 faces du substrat 1.

## Revendications

1. Procédé de fabrication de circuits intégrés à diode électroluminescente (23), comprenant les étapes suivantes:
- on fournit en continu un substrat (1) diélectrique flexible ayant une première (5) et une deuxième (7) faces principales, opposées l'une à l'autre par rapport à l'épaisseur du substrat (1), ce substrat comportant un premier feuillet (3) de matériau électriquement conducteur sur la première (5) face principale,
- on réalise au moins deux puits de connexion (9) s'étendant, entre les première (5) et deuxième (7) faces principales, par perforation à travers le substrat (1) et le premier feuillet (3) de matériau électriquement conducteur,
- on dépose un deuxième feuillet (11) de matériau électriquement conducteur, sur la deuxième face principale (7) du substrat (1), ce deuxième feuillet (11) de matériau électriquement conducteur obturant les puits de connexion (9),
- on réalise au moins une anode et une cathode (19) dans le deuxième feuillet (11) de matériau électriquement conducteur, situé sur la deuxième (7) face principale du substrat (1),
- on connecte au moins une diode électroluminescente (23) entre l'anode et la cathode (19),
- on encapsule la diode électroluminescente (19) dans une résine (29) située sur la première face (5) principale du substrat (1), tandis que l'anode et la cathode (19) sont situées sur la deuxième face (7) principale du substrat (1).

2. Procédé selon la revendication 1, dans lequel la diode électroluminescente (23) est connectée à l'anode et à la cathode (19) par des fils électriquement conducteurs (27) passant par les puits de connexion (9).

3. Procédé selon la revendication 1, dans lequel on réalise un puits de connexion (9) électriquement conducteur relié électriquement avec l'anode ou la cathode (19), on réalise au moins un plot de connexion (15) sur la première face (3) principale du substrat (1), relié électriquement au puits de connexion (9) et on connecte la diode électroluminescente (23) à ce plot de connexion (15) avec un fil conducteur (27).

4. Procédé selon la revendication 1 ou 3, dans lequel une piste (17) de matériau conducteur formant une forme géométrique fermée est réalisée sur la première face (3) du substrat (1) et dans lequel la résine (29) est dispensée sur la diode électroluminescente (23) à l'intérieur de la forme géométrique fermée.

5. Circuit intégré à diode électroluminescente, fabriqué avec un procédé selon l'une des revendications précédentes, comprenant
- un substrat (1) diélectrique flexible ayant une première (5) et une deuxième (7) faces principales, opposées l'une à l'autre par rapport à l'épaisseur du substrat (1), ce substrat comportant un premier feuillet (3) électriquement conducteur sur la première (5) face principale,
- au moins deux puits de connexion (9) s'étendant à travers le substrat (1) et le premier feuillet (3) de matériau électriquement conducteur,
- au moins une anode et une cathode (19) réalisées dans un feuillet (11) de matériau électriquement conducteur, situé sur la deuxième (7) face principale du substrat (1),
- au moins une diode électroluminescente (23) connectée entre l'anode et la cathode (19),
- une lentille (31) de résine (29) encapsulant la diode électroluminescente (23), la résine (29) étant située sur la première face (5) principale du substrat (1), tandis que l'anode et la cathode (19) sont situées sur la deuxième face (7) principale du substrat (1).

6. Circuit intégré selon la revendication 5, dans lequel la diode électroluminescente (23) est placée sur la première face (5) principale du substrat (1).

7. Circuit intégré selon la revendication 5 ou 6, dans lequel la diode électroluminescente (23) est connectée à l'anode et à la cathode (19) par des fils (27) électriquement conducteurs passant par les puits de connexion (9).

8. Circuit intégré selon la revendication 5 ou 6, comprenant un puits de connexion (9) électriquement conducteur relié électriquement avec l'anode ou la cathode (19), et au moins un plot de connexion (15) sur la première face (5) principale du substrat (1), relié électriquement au puits de connexion (9), la diode électroluminescente (23) étant connectée à ce plot de connexion (15) avec un fil conducteur (17).

9. Circuit intégré selon la revendication 5 à 8, comprenant une piste (17) de matériau conducteur formant une forme géométrique fermée réalisée sur la première face (5) du substrat (1) et dans lequel la résine (29) est dispensée sur la diode électroluminescente (23) à l'intérieur de la forme géométrique fermée pour former la lentille (31).

10. Ensemble de circuits intégrés selon l'une des revendications 5 à 9, se trouvant sur un même substrat (1) et électriquement connectés entre eux par des pistes conductrices se trouvant sur au moins l'une des premières (5) et deuxième (7) faces principales du substrat (1).

## Patentansprüche

1. Herstellungsverfahren von integrierten Schaltkreisen mit Leuchtdioden (23), umfassend die folgenden Schritte:
- ein flexibles dielektrisches Substrat (1), das eine erste (5) und eine zweite (7) Hauptfläche aufweist, die in Bezug auf die Dicke des Substrats (1) einander gegenüberliegend sind, wird kontinuierlich bereitgestellt, wobei dieses Substrat eine erste Schicht (3) aus elektrisch leitendem Material auf der ersten (5) Hauptfläche umfasst,
- mindestens zwei Verbindungsvertiefungen (9), die sich zwischen der ersten (5) und der zweiten (7) Hauptfläche erstrecken, werden durch Perforieren durch das Substrat (1) und die erste Schicht (3) aus elektrisch leitendem Material erstellt,
- eine zweite Schicht (11) aus elektrisch leitendem Material wird auf der zweiten Hauptfläche (7) des Substrats (1) aufgebracht, wobei diese zweite Schicht (11) aus elektrisch leitendem Material die Verbindungsvertiefungen (9) verschließt,
- mindestens eine Anode und eine Kathode (19) werden in der zweiten Schicht (11) aus elektrisch leitendem Material erstellt, die sich auf der zweiten (7) Hauptfläche des Substrats (1) befindet,
- mindestens eine Leuchtdiode (23) wird zwischen der Anode und der Kathode (19) angeschlossen,
- die Leuchtdiode (19) wird in einem Harz (29) eingekapselt, das sich auf der ersten Hauptfläche (5) des Substrats (1) befindet, während sich die Anode und die Kathode (19) auf der zweiten Hauptfläche (7) des Substrats (1) befinden.

2. Verfahren nach Anspruch 1, wobei die Leuchtdiode (23) durch elektrisch leitende Drähte (27), die durch die Verbindungsvertiefungen (9) laufen, mit der Anode und der Kathode (19) verbunden wird.

3. Verfahren nach Anspruch 1, wobei eine elektrisch leitende Verbindungsvertiefung (9) erstellt wird, die elektrisch mit der Anode oder der Kathode (19) verbunden wird, mindestens ein Anschlussstift (15) auf der ersten Hauptfläche (3) des Substrats (1) erstellt wird, der elektrisch mit den Verbindungsvertiefungen (9) verbunden wird, und die Leuchtdiode (23) mit einem leitenden Draht (27) an diesen Anschlussstift (15) angeschlossen wird.

4. Verfahren nach Anspruch 1 oder 3, wobei eine Bahn (17) aus leitendem Material, die eine geschlossene geometrische Form bildet, auf der ersten Hauptfläche (3) des Substrats (1) erstellt wird und wobei das Harz (29) im Inneren der geschlossenen geometrischen Form auf die Leuchtdiode (23) aufgebracht wird.

5. Integrierter Schaltkreis mit Leuchtdioden, der mit einem Verfahren nach einem der vorhergehenden Ansprüche hergestellt ist, umfassend
- ein flexibles dielektrisches Substrat (1), das eine erste (5) und eine zweite (7) Hauptfläche aufweist, die in Bezug auf die Dicke des Substrats (1) einander gegenüberliegend sind, wobei dieses Substrat eine erste Schicht (3) aus elektrisch leitendem Material auf der ersten (5) Hauptfläche umfasst,
- mindestens zwei Verbindungsvertiefungen (9), die sich durch das Substrat (1) und die erste Schicht (3) aus elektrisch leitendem Material erstrecken,
- mindestens eine Anode und eine Kathode (19), die in einer Schicht (11) aus elektrisch leitendem Material erstellt sind, die sich auf der zweiten (7) Hauptfläche des Substrats (1) befindet,
- mindestens eine Leuchtdiode (23), die zwischen der Anode und der Kathode (19) angeschlossen ist,
- eine Linse (31) aus Harz (29), das die Leuchtdiode (23) eingekapselt, wobei sich das Harz (29) auf der ersten Hauptfläche (5) des Substrats (1) befindet, während sich die Anode und die Kathode (19) auf der zweiten Hauptfläche (7) des Substrats (1) befinden.

6. Integrierter Schaltkreis nach Anspruch 5, wobei die Leuchtdiode (23) auf der ersten Hauptfläche (5) des Substrats (1) angeordnet ist.

7. Integrierter Schaltkreis nach Anspruch 5 oder 6, wobei die Leuchtdiode (23) durch elektrisch leitende Drähte (27), die durch die Verbindungsvertiefungen (9) laufen, mit der Anode und der Kathode (19) verbunden ist.

8. Integrierter Schaltkreis nach Anspruch 5 oder 6, umfassend eine elektrisch leitende Verbindungsvertiefung (9), die elektrisch mit der Anode oder der Kathode (19) verbunden ist, und mindestens einen Anschlussstift (15) auf der ersten Hauptfläche (5) des Substrats (1), der elektrisch mit den Verbindungsvertiefungen (9) verbunden ist, wobei die Leuchtdiode (23) mit einem leitenden Draht (17) an diesen Anschlussstift (15) angeschlossen ist.

9. Integrierter Schaltkreis nach Anspruch 5 bis 8, umfassend eine Bahn (17) aus leitendem Material, die eine geschlossene geometrische Form bildet, die auf der ersten Hauptfläche (5) des Substrats (1) erstellt ist, und wobei das Harz (29) im Inneren der geschlossenen geometrischen Form auf die Leuchtdiode (23) aufgebracht ist, um die Linse (31) zu bilden.

10. Anordnung von integrierten Schaltkreisen nach einem der Ansprüche 5 bis 9, die sich auf einem gleichen Substrat (1) befinden und durch Leiterbahnen, die sich auf mindestens einer der ersten und der zweiten (7) Hauptfläche (5) des Substrats (1) befinden, elektrisch miteinander verbunden sind.

## Claims

1. Process for manufacturing light-emitting-diode-comprising integrated circuits (23), comprising the following steps:
- a flexible dielectric substrate (1) having a first main face (5) and a second main face (7), which main faces are opposite each other with respect to the thickness of the substrate (1), is continuously delivered, this substrate comprising a first sheet (3) of electrically conductive material on the first main face (5),
- at least two connection vias (9) are produced between the first and second main faces (5, 7) by perforating the substrate (1) and first sheet (3) of electrically conductive material,
- a second sheet (11) of electrically conductive material is deposited on the second main face (7) of the substrate (1), this second sheet (11) of electrically conductive material obturating the connection vias (9),
- at least one anode and one cathode (19) are produced in the second sheet (11) of electrically conductive material located on the second main face (7) of the substrate (1),
- at least one light-emitting diode (23) is connected between the anode and cathode (19),
- the light-emitting diode (19) is encapsulated in a resin (29) located on the first main face (5) of the substrate (1), whereas the anode and the cathode (19) are located on the second main face (7) of the substrate (1).

2. Process according to Claim 1, wherein the light-emitting diode (23) is connected to the anode and to the cathode (19) by electrically conductive wires (27) passing through the connection vias (9).

3. Process according to Claim 1, wherein an electrically conductive connection via (9) electrically connected with the anode or the cathode (19) is produced, at least one connection pad (15) is produced on the first main face (3) of the substrate (1), which pad is electrically connected to the connection via (9), and the light-emitting diode (23) is connected to this connection pad (15) with a conductive wire (27).

4. Process according to Claim 1 or 3, wherein a track (17) of conductive material forming a closed geometric shape is produced on the first face (3) of the substrate (1) and wherein the resin (29) is dispensed onto the light-emitting diode (23) in the interior of the closed geometric shape.

5. Light-emitting-diode-comprising integrated circuit manufactured with a process according to one of the preceding claims, comprising
- a flexible dielectric substrate (1) having a first main face (5) and a second main face (7), which main faces are opposite each other with respect to the thickness of the substrate (1), this substrate comprising a first electrically conductive sheet (3) on the first main face (5),
- at least two connection vias (9) extending through the substrate (1) and the first sheet (3) of electrically conductive material,
- at least one anode and one cathode (19) produced in a sheet (11) of electrically conductive material located on the second main face (7) of the substrate (1),
- at least one light-emitting diode (23) connected between the anode and cathode (19),
- a resin (29) lens (31) encapsulating the light-emitting diode (23), the resin (29) being located on the first main face (5) of the substrate (1), whereas the anode and the cathode (19) are located on the second main face (7) of the substrate (1).

6. Integrated circuit according to Claim 5, wherein the light-emitting diode (23) is placed on the first main face (5) of the substrate (1).

7. Integrated circuit according to Claim 5 or 6, wherein the light-emitting diode (23) is connected to the anode and to the cathode (19) by electrically conductive wires (27) that pass through the connection vias (9).

8. Integrated circuit according to Claim 5 or 6, comprising an electrically conductive connection via (9) electrically connected with the anode or the cathode (19), and at least one connection pad (15) on the first main face (5) of the substrate (1), which is electrically connected to the connection via (9), the light-emitting diode (23) being connected to this connection pad (15) with a conductive wire (17).

9. Integrated circuit according to Claim 5 to 8, comprising a track (17) of conductive material forming a closed geometric shape produced on the first face (5) of the substrate (1) and wherein the resin (29) is dispensed onto the light-emitting diode (23) in the interior of the closed geometric shape to form the lens (31).

10. Set of integrated circuits according to one of Claims 5 to 9, located on the same substrate (1) and electrically connected together by conductive tracks located on at least one of the first and second main faces (5, 7) of the substrate (1).
